(19) Europäisches Patentamt
European Patent Office
Office européen des brevets

(11) **EP 3 921 461 B1**

(12) **FASCICULE DE BREVET EUROPEEN**

(45) Date de publication et mention de la délivrance du brevet:
**05.04.2023 Bulletin 2023/14**

(21) Numéro de dépôt: **20702505.7**

(22) Date de dépôt: **06.02.2020**

(51) Classification Internationale des Brevets (IPC):
**C30B 15/10** $^{(2006.01)}$ **C30B 15/14** $^{(2006.01)}$
**C30B 15/30** $^{(2006.01)}$ **C30B 29/06** $^{(2006.01)}$
**C30B 35/00** $^{(2006.01)}$ **F27B 14/10** $^{(2006.01)}$
**H05B 6/24** $^{(2006.01)}$

(52) Classification Coopérative des Brevets (CPC):
**H05B 6/24; C30B 15/10; C30B 15/14; C30B 15/30; C30B 29/06; C30B 35/002; F27B 14/10;**
F27B 2014/108

(86) Numéro de dépôt international:
**PCT/EP2020/053046**

(87) Numéro de publication internationale:
**WO 2020/161264 (13.08.2020 Gazette 2020/33)**

(54) **CREUSET FROID**

KALTSCHMELZTIEGEL

COLD CRUCIBLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.02.2019 FR 1901243**

(43) Date de publication de la demande:
**15.12.2021 Bulletin 2021/50**

(73) Titulaires:
• **Institut Polytechnique de Grenoble
38000 Grenoble (FR)**
• **Centre national de la recherche scientifique
75016 Paris (FR)**
• **Université Grenoble Alpes
38400 Saint-Martin-d'Hères (FR)**

(72) Inventeurs:
• **ZAIDAT, Kader
38400 SAINT MARTIN D'HERES (FR)**
• **GARNIER, Christian
38320 EYBENS (FR)**
• **HASAN, Ghatfan
38400 SAINT MARTIN D'HERES (FR)**

(74) Mandataire: **Hautier IP
20, rue de la Liberté
06000 Nice (FR)**

(56) Documents cités:
DE-A1- 10 042 151   JP-A- H1 152 095
US-A- 5 109 389   US-A1- 2007 147 463

# Description

## DOMAINE TECHNIQUE

L'invention concerne le domaine des creusets froids. Elle trouve pour application particulièrement avantageuse le domaine de l'élaboration de matériaux monocristallins à haute température.

De façon connue, un creuset froid comprend :

- une cage dite froide comprenant au moins un secteur en un matériau bon conducteur électrique, généralement en cuivre, et dans laquelle une charge à fondre est destinée à être introduite, et
- un dispositif de refroidissement à fluide caloporteur, généralement de l'eau, le dispositif de refroidissement étant configuré pour refroidir chaque secteur de la cage froide.

Chaque creuset froid utilise, pour fonctionner, un courant alternatif paramétré pour induire, dans la cage froide, une induction électromagnétique conduisant à la fusion de la charge. Généralement, ledit courant alternatif est injecté dans une spire d'induction électromagnétique entourant la cage froide.

Chaque creuset froid peut en outre être utilisé avec un dispositif d'alimentation en continu du matériau constitutif de la charge.

## ÉTAT DE LA TECHNIQUE

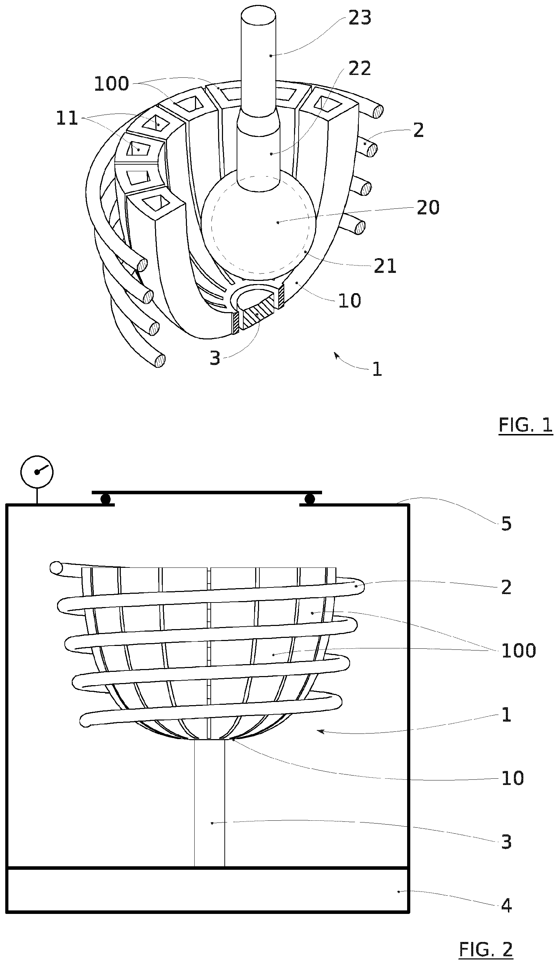

Il existe plusieurs types de creusets froids dont deux sont illustrés sur les figures 1 et 2 annexées. D'autres types de creusets froids existent qui ne sont pas illustrés ici qui comprennent par exemple les modèles dits à double creuset. Quel que soit le type de creuset considéré, son principe de fonctionnement est sensiblement commun aux autres ; il est tel qu'introduit ci-dessous en référence aux figures 1 et 2.

Le creuset froid 1 et la spire 2 sont placé dans une enceinte hermétique 5 à atmosphère contrôlé, de préférence exempt d'oxygène, souvent remplie d'un gaz inerte tel que de l'Argon, à une pression déterminée.

Lorsque l'on injecte un courant alternatif dans la spire 2 entourant la cage froide 10, il apparaît des courants induits dans chacun des secteurs 100 refroidis de la cage, ces courants produisent à leurs tours un courant de Foucault dans l'épaisseur de peau, dite électromagnétique, d'une charge 20 située dans la cage. Ces courants de Foucault permettent de chauffer la charge 20, le cas échéant jusqu'à sa fusion, sans pour autant que le creuset froid 1 ne chauffe.

Bien entendu, le chauffage de la charge étant obtenue par induction électromagnétique, il faut que la charge 20 soit conductrice électriquement. L'épaisseur de peau électromagnétique 21 de la charge 20 est fonction de la résistivité de cette charge et de la fréquence utilisée pour le courant alternatif injecté dans la spire 2.

Notons que cette peau électromagnétique 21 est la partie de la charge 20 située au plus près de la cage froide 10.

Le creuset froid 1 peut en outre être utilisé pour fondre des matériaux semi-conducteurs. À cette fin, le creuset froid 1 est mis en oeuvre, de façon connue, avec un dispositif de préchauffage de la charge 20 pour la rendre conductrice. Ce dispositif de préchauffage (non représenté) comprend généralement un couvercle en graphite agencé au-dessus du creuset froid 1 et le cas échéant muni d'un système de ventilation à flux de gaz configuré pour éviter toute pollution de la charge 20 par le graphite du couvercle.

Les avantages connus de cette technologie sont : la lévitation de la charge 20 en fusion qui explique notamment la relative inusabilité des creusets froids 1, la potentielle absence de pollution extérieure (notamment par de l'oxygène ou du graphite) dans les matériaux 22 élaborés et un brassage de la charge 20 en fusion permettant l'élaboration de matériaux 22, et notamment d'alliage, de très bonne homogénéité.

Les creusets froids sont actuellement utilisés pour l'élaboration d'alliages métalliques, par exemple à base de Titane, Nobium, etc. L'utilisation des creusets froids dans la métallurgie est effectivement devenue un outil très apprécié pour sa qualité de brassage qui permet d'obtenir des alliages très homogènes en composition. Cette homogénéité est assurée par un brassage virulent dû à la présence d'une force électromagnétique très grande, notamment observable dans l'épaisseur de la peau électromagnétique de la charge en fusion.

Il suffit de couper le courant alternatif circulant dans la spire 2 de sorte à arrêter la lévitation de la charge 20 en fusion, tout en retirant un bouchon 3 bouchant jusque-là le fond du creuset froid 1, de la façon illustrée sur la figure 1, pour que la charge en fusion coule dans un moule situé sous le creuset froid.

En référence à la figure 1, l'utilisation de creusets froids 1 a également été envisagée pour élaborer des monocristaux, notamment des matériaux semi-conducteurs. Cette technique utilise un germe parfaitement monocristallin pour initier la croissance de lingots monocristallins 22. Le germe 23 est introduit dans la charge 20 en fusion du matériau à cristalliser, puis l'ensemble composé du germe 23 et du monocristal 22 en croissance sur le germe 23 et déplacé vers le haut (Cf. figure 1) ou vers le bas (Cf. figure 2, et notamment les éléments référencés 3 (doigt refroidi) et 4 (plateau de translation verticale)) pour faire croître le monocristal 22 en longueur, et idéalement en diamètre.

Toutefois, comme le montrent les études mentionnées ci-dessous, cette utilisation est très vite limitée, en termes de croissance en diamètre du monocristal 22. En effet, la croissance de lingots monocristallins 22 dont le diamètre serait significativement supérieur à celui du germe 23 permettant d'initier la croissance n'a pu être obtenue à ce jour.

Par exemple, l'utilisation d'un creuset froid a été testée dans les années 1970, par Wenckus et al. pour élaborer des lingots monocristallins de silicium, puis par Osiko et al. sur des oxydes.

Plus particulièrement, Wenckus et al. (GROWTH OF HIGH PURITY OXYGEN-FREE SILICON BY COLD CRUCIBLE TECHNIQUES, Final technical report, 18 May 80 - 30 Nov. 81) ont montré que l'utilisation d'un creuset froid pour réaliser des monocristaux de silicium était très pertinente car cela permet d'avoir des monocristaux de silicium sans contamination extérieure. Plus particulièrement, Wenckus et al. ont réussi à faire croitre un monocristal avec un taux d'oxygène largement inférieur à celui d'un monocristal réalisé de façon conventionnelle avec un creuset chaud en silice. Toutefois, les lingots monocristallins purs de silicium ainsi réalisés sont d'un diamètre, relativement petite (1,5 cm de diamètre), comparable au diamètre du germe employé pour initier leur croissance.

En parallèle, Osiko et al. (CRUCIBLE-FREE METHODS OF GROWING OXIDE CRYSTALS FROM THE MELT, Ann. Rev. Mater. Sci. 1987. I7: 101-22) ont montré qu'il était possible d'utiliser des creusets froids pour la croissance de lingots monocristallins en oxyde. Toutefois, les lingots d'oxyde ainsi réalisés sont encore d'un diamètre comparable au diamètre du germe employé pour initier leur croissance. Osiko et al. ont supposé que cette limitation est due à l'intensité et la direction du brassage qui seraient néfastes à la croissance de monocristaux de diamètre significativement plus grand que le germe utilisé. Afin de pallier ce problème, Osiko et al. propose d'utiliser des modèles à double creuset. Dans ce modèle, un second système refroidi est introduit dans la région où le germe est inséré pour y contrôler la direction et l'intensité de l'écoulement de la charge en fusion. Ceci a pour effet immédiat la contamination des monocristaux réalisés.

Par ailleurs, dans les 1980, Ciszek (Growth and Properties of (100) and (111) dislocation free silicon crystals from a cold crucible, Journal of Crystal Growth 70, 324-329, 1984) a étudié la croissance de monocristaux de silicium dans un creuset froid pour des applications photovoltaïques. S'il n'a pu faire croitre (comme Wenckus et Osiko), que des lingots monocristallins de petit diamètre, Ciszek a tout de même démontré que les cellules photovoltaïques obtenues par cette méthode étaient d'un meilleur rendement de conversion que celles obtenues de façon conventionnelle.

Enfin, dans les années 2000, Gillon et al. (Uses of intense d.c. magnetic fields in materials processing, Materials Science and Engineering A287 (2000) 146-152) ont introduit un creuset froid contenant une charge de titane dans un champ magnétique statique intense (8T) créé par une bobine supraconductrice agencée autour du creuset froid. Ils ont démontré que le brassage de la charge en fusion dans le creuset froid était freiné par la présence du champ magnétique statique. En effet, une force de freinage proportionnelle au produit vectoriel de la vitesse de brassage de la charge en fusion et du champ magnétique statique appliqué permet de stabiliser les turbulences induites dans la charge en fusion par les courants de Foucault.

Par ailleurs, des creusets froids sont décrits par les documents de brevet référencés US 2007/0147463 A1, JP H11 52095 A, US 5,109,389 et DE 100 42 151 A1.

Un objet de la présente invention est donc de proposer un creuset froid permettant de pallier au moins en partie les inconvénients susmentionnés. Un objet de la présente invention est plus particulièrement de proposer un creuset froid permettant de réaliser des lingots monocristallins de dimensions, notamment transversales, significativement plus grandes relativement aux dimensions, notamment transversales, du germe permettant d'initier leur croissance.

Les autres objets, caractéristiques et avantages de la présente invention apparaîtront à l'examen de la description suivante et des dessins d'accompagnement. Il est entendu que d'autres avantages peuvent être incorporés.

## RÉSUMÉ

Pour atteindre cet objectif, selon un mode de réalisation, la présente invention prévoit un creuset froid, par ailleurs conforme à la définition générique qu'en donne le préambule ci-dessus, essentiellement tel qu'il comprend au moins un dispositif de génération d'un champ électromagnétique, chaque dispositif étant logé à l'intérieur d'au moins un secteur de la cage froide du creuset froid.

Chaque dispositif de génération est de préférence configuré pour générer un champ magnétique statique (ou quasi-statique).

Chaque dispositif de génération est plus particulièrement configuré pour générer un champ électromagnétique, et de préférence un champ magnétique statique, de densité suffisante pour être ressenti par une charge en fusion dans la cage froide, et plus particulièrement au moins, voire uniquement, dans une épaisseur de peau électromagnétique d'une charge en fusion dans la cage froide. Chaque champ électromagnétique a ainsi pour effet de freiner le brassage électromagnétique de la charge en fusion.

Dès lors, le creuset froid selon l'invention permet de réaliser successivement des lingots monocristallins de diamètre significativement plus grand relativement au diamètre du germe permettant d'initier leur croissance. De tels lingots monocristallins peuvent être réalisés en divers matériaux conducteurs ou semi-conducteurs. Des tranches (ou wafers) découpées dans des lingots monocristallins en matériaux semi-conducteurs ainsi réalisés peuvent avantageusement trouver à s'appliquer dans de nombreux domaines, et notamment dans le domaine de l'électronique de puissance.

Chaque dispositif de génération d'un champ magnétique est plus spécifiquement configuré pour générer un champ électromagnétique, et de préférence un champ magnétique statique, présentant une densité sensiblement supérieure à 0,02 T, de préférence sensiblement supérieure à 0,05 T, à une distance sensiblement supérieure à 2 mm depuis un de ses bords orienté vers l'intérieur de la cage froide.

Par exemple, chaque dispositif de génération d'un champ magnétique est configuré pour générer un champ électromagnétique, et de préférence un champ magnétique statique, présentant une densité sensiblement comprise entre 0,07 et 0,8 T (plus préférentiellement sensiblement comprise entre 0,1 et 0,3 T), à une distance sensiblement comprise entre 0,1 et 12 mm du dispositif de génération (plus préférentiellement sensiblement comprise entre 4 et 10 mm) depuis un de ses bords orienté vers l'intérieur de la cage froide.

Chaque dispositif de génération est plus particulièrement logé dans ledit au moins un secteur de sorte à se situer, par un de ses bords orienté vers l'intérieur de la cage froide, à une distance sensiblement inférieure à 12 mm, de préférence sensiblement inférieure à 9 mm, et encore plus préférentiellement sensiblement inférieure à 6 mm, de la charge en fusion dans le creuset froid.

Chaque secteur étant à base d'un matériau peu résistif, en général en cuivre, sert de bouclier (électromagnétique) pour protéger le dispositif de génération qu'il loge. En effet, les courants induits dans les secteurs passent ainsi naturellement dans l'épaisseur des parois, par exemple en cuivre, des secteurs.

En outre, chaque dispositif de génération est configuré dans le secteur qui le loge de sorte à être refroidi par le dispositif de refroidissement du creuset froid. Un même dispositif de refroidissement peut permettre de garantir le maintien d'une température contrôlée des dispositifs de génération et des secteurs.

Selon un mode de réalisation préféré de l'invention, au moins un dispositif de génération comprend au moins un aimant permanent. L'agencement conjoint de chaque aimant permanent avec le dispositif de refroidissement est alors plus particulièrement configuré pour garantir le maintien de l'aimant permanent à une température toujours inférieure, à la température de Curie au-delà de laquelle l'aimant perd son aimantation. De préférence, chaque aimant permanent est plus particulièrement tel qu'il génère un champ magnétique statique d'une densité sensiblement égale à 0,8 T à 2 mm de distance de ses bords. Chaque aimant permanent est de préférence constitué en un matériau présentant une résistivité électrique supérieure à celle du matériau constitutif des secteurs de la cage froide. Chaque aimant permanent est par exemple en un matériau à base de Fer et/ou de Néodyme.

Selon un mode de réalisation préféré de l'invention, au moins un dispositif de génération d'un champ magnétique statique comprend une pluralité d'aimants permanents. Les aimants permanents de chaque pluralité sont de préférence agencés entre eux de sorte à générer, au moins en direction de l'intérieur de la cage froide, un champ magnétique statique plus puissant, en termes de valeur de champ magnétique que le champ magnétique statique généré par chaque aimant permanent pris isolément. Les aimants permanents de chaque pluralité sont par exemple agencés entre eux selon une configuration dite de Halbach.

De manière facultative, l'invention peut en outre présenter au moins l'une quelconque des caractéristiques suivantes :

- la cage froide comprenant plusieurs secteurs, les secteurs sont amovibles entre eux. Le cas échéant, le creuset froid comprend en outre un dispositif de fixation et de maintien des secteurs entre eux, ce dispositif étant configuré de sorte que les secteurs fixés et maintenus forment au moins une partie de la cage froide. Selon un mode de réalisation de l'invention, le dispositif de fixation et de maintien comprend une base, en général en acier inoxydable, configurée pour y fixer de façon amovible chaque secteur du creuset froid de sorte que les secteurs et la base forment ensemble la cage froide. De préférence, la fixation de chaque secteur sur la base est configurée pour permettre la circulation du fluide caloporteur du dispositif de refroidissement à travers la base dans le secteur. Un joint d'étanchéité, prenant par exemple la forme d'un joint de culasse ou d'un joint torique, peut le cas échéant être agencé entre la base et les secteurs, ou directement entre les secteurs et le dispositif de refroidissement, notamment en l'absence de base ;

- De préférence, au moins un dispositif de génération comprend une première partie configurée pour générer le champ électromagnétique, de préférence pour générer le champ magnétique statique, et une deuxième partie, dite partie de support, configurée pour supporter la première partie du dispositif de génération et pour coopérer étroitement avec le logement du dispositif de génération dans le secteur. De préférence, la partie de support du dispositif de génération est configurée pour supporter une pluralité d'aimants permanents, par exemple agencés entre eux selon une configuration dite de Halbach. En alternative, ou en complément, le support est configuré pour former avec les parois intérieures de son logement dans le secteur, et le cas échéant avec la première partie du dispositif de génération qu'il supporte, un couloir de circulation pour le fluide caloporteur du dispositif de refroidissement ;

- Selon un mode de réalisation particulier, seuls deux secteurs opposés l'un à l'autre logent un dispositif de génération tel qu'introduit ci-dessus ;

- Selon un autre mode de réalisation particulier, seuls trois secteurs agencés sensiblement selon une symétrie de rotation d'ordre 3 logent un dispositif de génération tel qu'introduit ci-dessus ;

- Selon un autre mode de réalisation particulier, seuls quatre secteurs agencés sensiblement selon une symétrie de rotation d'ordre 4 logent un dispositif de génération tel qu'introduit ci-dessus ;

- Selon un autre mode de réalisation particulier, un secteur sur deux secteurs adjacents loge un dispositif de génération tel qu'introduit ci-dessus ;
- Selon un autre mode de réalisation particulier, chaque secteur loge un dispositif de génération tel qu'introduit ci-dessus.

Chaque secteur dont le logement est exempt de dispositif de génération peut loger au moins l'un parmi : un matériau à base de ferrite, une sonde de mesure ou un dispositif permettant de modifier ou analyser la charge en fusion.

Le creuset froid selon l'invention peut être conçu par intégration du dispositif de génération dans un creuset froid de n'importe quel type existant, dont un creuset froid à cage froide cylindrique, un creuset froid dit de poche, avec ou sans secteur(s) amovible(s) et un creuset froid à spire directe.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente schématiquement une vue en perspective d'un creuset froid selon l'art antérieur ouvert en deux, agencé conjointement avec une spire d'induction électromagnétique et comprenant une charge depuis laquelle un germe est progressivement retiré pour faire croître un monocristal ;
La figure 2 représente schématiquement une vue de face en transparence d'une enceinte hermétique contenant un creuset froid selon un autre art antérieur que celui illustré sur la figure 1 ;
La figure 3 représente une vue en perspective d'un mode de réalisation préféré du creuset froid selon l'invention équipé d'un dispositif de refroidissement ;
La figure 4 est une vue en perspective et en éclaté du creuset froid et du dispositif de refroidissement illustré sur la figure 3 ;
La figure 5 est une vue en perspective d'un dispositif de génération de champ magnétique statique selon le mode de réalisation préféré de l'invention ;
La figure 6 est une vue en perspective par le dessous d'un secteur selon le mode de réalisation préféré de l'invention ;
La figure 7 est une vue en perspective et en transparence du secteur illustré sur la figure 6 ;
La figure 8 est une représentation schématique d'un agencement d'aimants permanents selon une configuration de Halbach et des lignes isomagnétiques produites par cet agencement ; et
Les figures 9 et 10 sont des résultats de simulation d'un modèle multi-physique démontrant l'efficacité du creuset froid selon l'invention (figure 10) relativement à celle d'un creuset froid selon l'art antérieur (figure 9).

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

DESCRIPTION DÉTAILLÉE

On entend par « inférieur » et « supérieur », « inférieur ou égal » et supérieur ou égal », respectivement. L'égalité est exclue par l'usage des termes « strictement inférieur » et « strictement supérieur ». Egalement, les expressions du type « égal, inférieur, supérieur » s'entendent de comparaisons pouvant accommoder certaines tolérances, notamment selon l'échelle de grandeur des valeurs comparées et les incertitudes de mesure. Des valeurs sensiblement égales, inférieures ou supérieures entrent dans le cadre d'interprétation de l'invention.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Il est précisé que dans le cadre de la présente invention, le terme « sur », « surmonte », « recouvre » ou « sous-jacent » ou leurs équivalents ne signifient pas forcément « au contact de ».

On entend par « agencé conjointement avec » la relation fonctionnelle de deux éléments structurels entre eux selon laquelle l'un au moins est agencé en fonction de l'autre élément. En particulier, l'un des éléments peut être agencé en fonction des dimensions et formes de l'autre élément et/ou selon une disposition particulière définie par rapport à une implantation de l'autre élément, pour réaliser ensemble une fonction particulière. Ces termes visent donc à couvrir une multitude d'agencements relatifs de deux éléments structurels entre eux, multitude qu'il serait nécessairement vain de vouloir détailler exhaustivement.

On entend par un élément à base d'un matériau A, un élément comprenant ce matériau A et éventuellement d'autres matériaux.

On entend par « champ électromagnétique », un champ représenté par l'ensemble ($\vec{E}$, $\vec{B}$), où $\vec{E}$ est le champ électrique et $\vec{B}$ est le champ magnétique, tel qu'une particule de charge $\vec{q}$ et de vecteur vitesse $\vec{v}$; subit une force qui s'exprime par :

$$\vec{F} = q\left(\vec{E} + \left[\vec{v} \wedge \vec{B}\right]\right)$$

La définition du champ électromagnétique comprend ici celle d'un champ magnétique, et a *fortiori* celle d'un champ magnétique statique, qui constituent des cas particuliers de champ électromagnétique.

On entend, par une configuration de Halbach, un arrangement spécial d'aimants permanents qui augmentent le champ magnétique d'un côté de l'arrangement tout en annulant quasiment le champ de l'autre côté.

On entend, par matériau bon conducteur électrique, un matériau dont la résistivité électrique est sensiblement inférieure à $6.10^{-8}$ ohm.m, de préférence sensiblement inférieure à $2.10^{-8}$ ohm.m.

Comme établi par les inventeurs de la présente invention, lors de l'utilisation d'un creuset froid classique pour l'élaboration de matériaux à partir d'une charge 20 en fusion, il apparaît des instabilités dans la charge 20 en fusion. Ces instabilités sont la conséquence d'un brassage intense dû à la force de Lorentz qui peuvent avoir des conséquences drastiques sur le matériau élaboré. Comme cela apparaîtra à la lecture de la description détaillée qui suit, l'invention fournit un creuset froid adapté pour atténuer les instabilités susmentionnées dans la charge en fusion et lever leurs conséquences, notamment en termes de limitation en taille, sur le matériau élaboré.

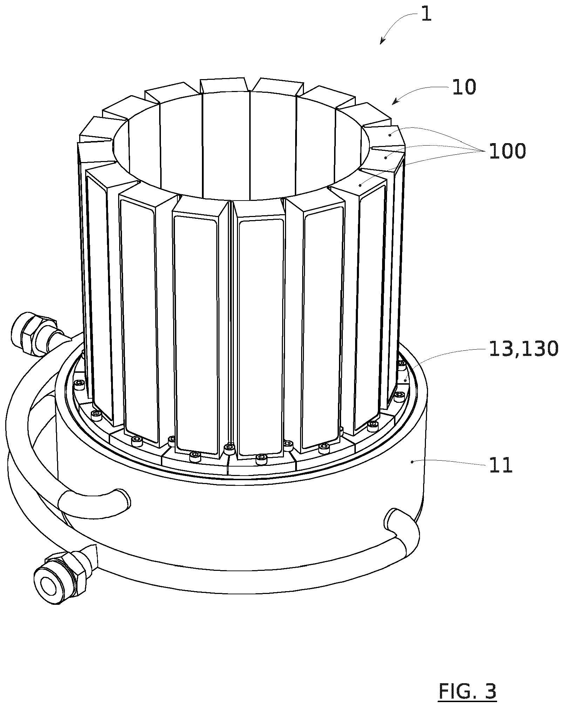

Pour ce faire, l'invention propose plus particulièrement un creuset froid 1, tel que par exemple illustré sur la figure 3, qui, contrairement à un creuset froid classique, comprend en outre un dispositif de génération 12 d'un champ électromagnétique, de préférence un dispositif de génération 12 d'un champ magnétique statique, logé dans au moins un secteur 100 de la cage froide 10 du creuset froid 1.

Un mode de réalisation préféré de l'invention est décrit ci-dessous en référence aux figures 3 à 7.

Le creuset froid 1 illustré sur la figure 3 comprend une cage froide 10 de forme sensiblement cylindrique délimitant un espace intérieur destiné à recevoir une charge à fondre. La cage froide 10 est plus particulièrement constituée d'au moins une pluralité de secteurs 100. De façon connue, les secteurs 100 ne sont pas en conduction électrique les uns avec les autres par au moins une partie de leurs bords longitudinaux. Sur cette partie, une lame d'air peut être ménagée entre deux secteurs adjacents. En alternative, chaque fente entre deux secteurs adjacents peut être remplie d'un insert magnétique. Un tel insert peut plus particulièrement être constitué à base d'un matériau composite magnétique doux.

Chaque secteur 100 du creuset froid 1 illustré sur la figure 3 est fixé par une base 130, jouant le rôle d'un dispositif de fixation et de maintien 13 des secteurs 100. Plus particulièrement, le dispositif 13 permet de fixer les secteurs 100 sur un dispositif de refroidissement 11 et permet de maintenir les secteurs 100 en une position spécifique les uns par rapport aux autres sur le dispositif de refroidissement 11. Ainsi fixés et maintenus, les secteurs 100 forment l'essentiel de la cage froide 11. En alternative, les segments peuvent partager ensemble une même base 130 sur laquelle ils seraient fixés et maintenus, la base étant à son tour fixée au dispositif de refroidissement 11.

Le creuset froid 1 illustré sur la figure 3 comprend donc un dispositif de refroidissement 11 du type à fluide caloporteur, par exemple de l'eau. Un tel dispositif de refroidissement 11 peut être tel que connu de l'art antérieur. Le creuset froid 1 selon l'invention peut donc ne pas nécessiter le développement ou même l'adaptation des dispositifs de refroidissement 11 connus qui peuvent donc avantageusement être utilisés tels quels.

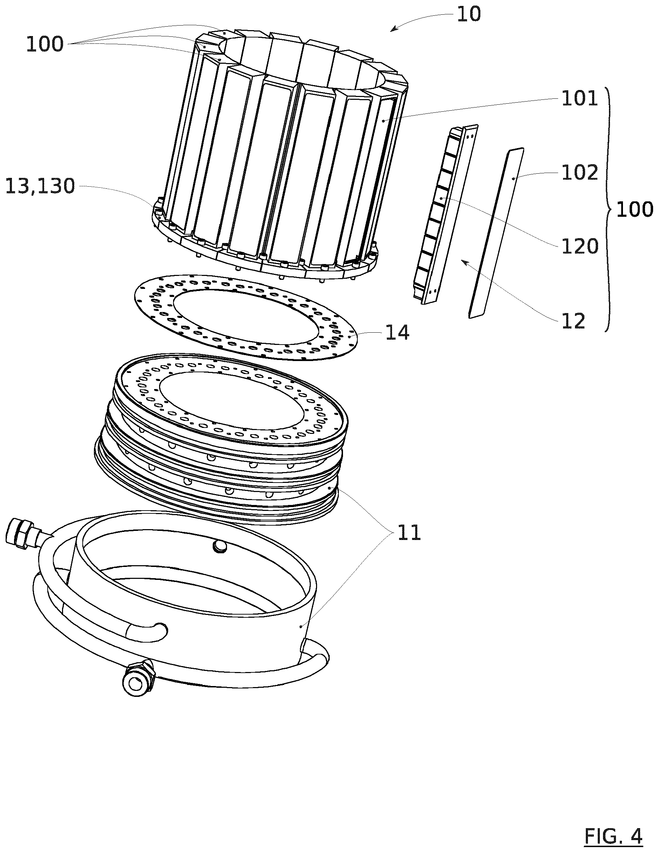

Comme illustré sur la figure 4, le dispositif de refroidissement 11 peut comprendre deux parties. Une première partie (en bas de la figure 4) par laquelle le fluide caloporteur est introduit dans, puis extrait depuis, une deuxième partie du dispositif de refroidissement 11 définissant un ou plusieurs circuits de circulation passant en partie à l'intérieur des secteurs 100 pour les refroidir.

Un joint 14, prenant ici la forme d'un joint de culasse, peut-être disposé entre la deuxième partie du dispositif de refroidissement 11 et chaque base 130, de sorte à assurer une étanchéité entre ces pièces. En alternative les secteurs peuvent s'étendre par leur base 130 par une entrée et une sortie de fluide caloporteur faisant chacune saillie depuis la surface plane de la base 130 et étant chacune destinée à être insérée dans des alésages correspondants du dispositif de refroidissement ou d'une pièce intermédiaire (non représentée) entre le dispositif de refroidissement et l'ensemble des secteurs 100. L'étanchéité entre chaque secteur 100 et le dispositif de refroidissement 11 peut alors être réalisée par un ou plusieurs joints toriques répartis le long des saillies d'entrée et de sortie du fluide caloporteur.

Sur la figure 4, une vue partiellement éclatée de la cage froide 10 est également représentée. Les secteurs 100 sont fixés entre eux par leur base 130. Plus particulièrement, l'un des secteurs 100 est illustré en vue éclatée. Il apparaît ainsi que chaque secteur 100 peut comporter un logement 101 dans lequel le dispositif de génération 12 est logé.

Plus particulièrement, le logement 101 peut être fermé, de préférence par son côté opposé à l'espace intérieur de la cage froide 10, par une plaque 102, en laiton ou en cuivre, fixée, de préférence par soudure, de sorte à être en conduction électrique avec les autres parois définissant le logement 101. Une telle conception peut être la conséquence d'un évidement d'un secteur d'un creuset froid classique pour y former le logement 101 et pouvoir y loger le dispositif de génération 12. Un creuset froid classique comprend en effet uniquement une partie du canal de circulation du fluide caloporteur destiné à permettre son refroidissement ; il n'est donc a priori pas permis d'y loger un quelconque dispositif, ici un dispositif de génération 12, du moins pas sans affecter le refroidissement du secteur. En alternative, chaque secteur 100 peut avoir été conçu de sorte à présenter un logement 101 propre et destiné à recevoir un dispositif de génération 12.

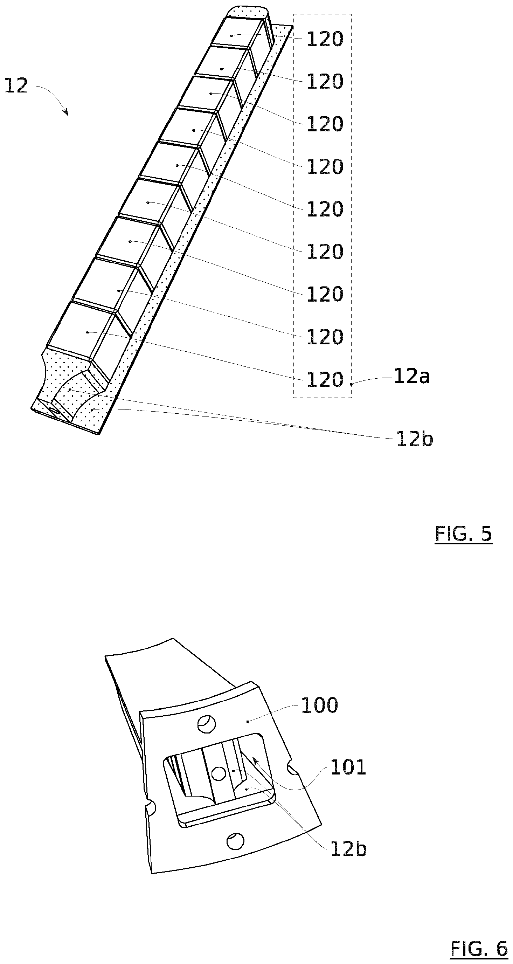

Le dispositif de génération 12 tel qu'illustré sur la figure 4 est plus particulièrement représenté sur la figure 5. Cette figure illustre en particulier le fait que, selon le mode de réalisation préféré de l'invention, le dispositif de génération 12 comprend essentiellement deux parties 12a et 12b. Une première partie 12a est configurée pour générer le champ magnétique statique. Une deuxième partie, dite partie de support 12b, est configurée pour supporter la première partie 12a du dispositif de génération 12. Plus particulièrement, la partie de support 12b comprend une plaque sensiblement longitudinale depuis laquelle s'étendent deux éléments de maintien. La première partie 12a du dispositif de génération est fixée et maintenue entre les deux éléments de maintien de la partie de support 12b. Les deux éléments de maintien sont en outre configurés de sorte à réserver une partie du circuit de circulation de fluide caloporteur dans le secteur 100, et plus particulièrement dans l'espace du logement 101 inoccupé par le dispositif de génération 12, autour de la première partie 12a du dispositif de génération 12. Ainsi, un premier des deux éléments de maintien (celui du bas de la figure 5) constitue un type d'îlot central de part et d'autre duquel le fluide caloporteur est destiné à circuler en sens opposés ; le second des deux éléments de maintien (celui du haut de la figure 5) constitue l'intérieur d'un méandre du circuit de circulation.

Une vue en perspective de dessous d'un des secteurs 100 illustré sur la figure 3 est illustrée sur la figure 6. Il y est illustré que le logement 101 est ouvert par sa base 130. Une série d'alésages traversant et/ou de retraits de matière peut être prévue dans des extensions de la base 130 à fin de fixation à des bases de secteurs adjacents et/ou de fixation au dispositif de refroidissement 11 à travers le joint de culasse 14. Plus particulièrement, les retraits de matière de deux segments 100 adjacents entre eux peuvent être destinés à coopérer ensemble à fin de fixation de ces segments entre eux. Il est également illustré sur la figure 6 que le dispositif de génération 12 est logé de façon étroite dans le logement 101. Notamment, la deuxième partie 12b comprend une plaque longitudinale configurée pour couvrir de préférence la totalité de la surface intérieure du logement 101 qui est à l'opposé de l'espace intérieur de la cage froide 10 ; et la surface de la première partie 12a du dispositif de génération 12 est en appui, ou du moins en contact, avec la surface intérieure du logement 101 qui est orientée vers l'espace intérieur de la cage froide 10. De la sorte, l'on évite tout mouvement du dispositif de génération 12 dans son logement 101 qui y est donc maintenu immobile. Ainsi, il apparaît également que l'ensemble formé du secteur 100 et du dispositif de génération 12 adéquatement placé dans le secteur 100 définit la partie de circuit de circulation susmentionnée sous la forme d'un U débouchant par la base 130 du secteur 100. On remarque que, dans cette configuration, la première partie 12a du dispositif de génération 12, configurée pour générer le champ magnétique statique, est située au plus près de l'espace intérieur de la cage froide 10. Plus particulièrement, seule l'épaisseur de la paroi longitudinale du secteur 100 qui est orientée vers l'espace intérieur de la cage froide 10 sépare la première partie 12a du dispositif de génération 12 et l'espace intérieur de la cage froide 10. L'épaisseur de cette paroi est par exemple comprise entre 0,5 et 2 mm, de préférence comprise entre 0,7 et 1,5 mm.

L'on comprend que le dispositif de génération 12 est ainsi plus particulièrement logé dans son secteur 100 de sorte à se situer, par son bord orienté vers l'intérieur de la cage froide 10, à une distance sensiblement inférieure à 12 mm, de préférence sensiblement inférieure à 9 mm, et encore plus préférentiellement sensiblement inférieure à 6 mm, de la charge 20 en fusion dans le creuset froid 1.

En outre, il apparaît que, par construction, le dispositif de génération 12 est configuré de sorte à être refroidi par le dispositif de refroidissement 11 déjà en charge du refroidissement du secteur 100 dans lequel le dispositif de génération 12 est logé.

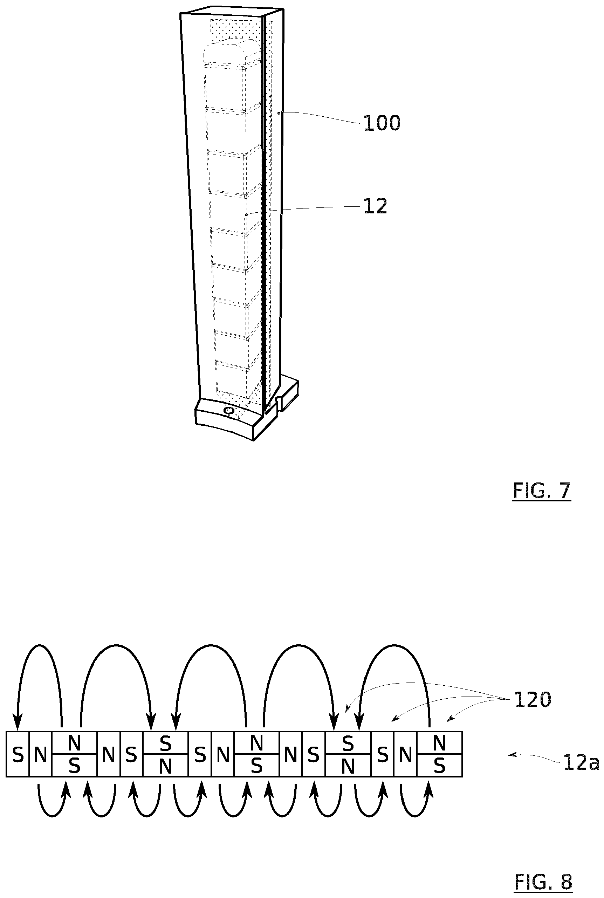

La première partie 12a du dispositif de génération 12 selon le mode de réalisation préféré de l'invention est décrite ci-dessous en référence aux figures 5 et 7.

Comme illustré, la première partie 12a du dispositif de génération 12 comprend, de façon non limitative, une pluralité de neuf aimants permanents 120. Dès lors, l'on comprend que le dispositif de refroidissement 11 est de préférence configuré et/ou paramétré pour garantir le maintien de chaque aimant permanent à une température strictement inférieure à la température de Curie de cet aimant ; sans quoi, l'aimantation de l'aimant permanent serait perdue.

Chaque aimant permanent peut présenter une géométrie sensiblement cubique, dont les arêtes sont par exemple sensiblement égales à 2 cm. Bien sûr, la géométrie et les dimensions de chaque aimant permanent doivent être adaptées aux dimensions du logement 101, et plus généralement du secteur 100. Chaque aimant permanent 120 peut plus particulièrement être constitué à base d'un alliage néodyme/fer/bore. Un tel alliage présente une résistivité électrique supérieure, et plus particulièrement au moins deux fois supérieure, à celle du cuivre constituant les secteurs 100 de la cage froide 10. Les aimants permanents 120 sont alignés entre eux et maintenus alignés par et entre les deux éléments de maintien de la partie de support 12b du dispositif de génération 12. Cet alignement est plus particulièrement tel que les aimants permanents 120 sont agencés entre eux selon une configuration dite de Halbach. Une telle configuration est connue pour permettre, comme illustré sur la figure 8, de générer, dans une direction perpendiculaire à l'alignement, un champ magnétique statique plus puissant que dans une autre direction perpendiculaire à l'alignement.

L'agencement de l'alignement sur la partie de support est corrélé à la disposition attendue du dispositif de génération 12 dans le logement 101 de son secteur. Plus particulièrement, le dispositif de génération 12 est disposé dans son logement 101 de sorte que le côté par lequel l'alignement des aimants permanents génère un champ magnétique statique plus puissant soit situé directement en regard de, et de préférence au contact de, la paroi longitudinale du secteur 100 qui est orientée vers l'espace intérieur de la cage froide 10.

Avec des aimants permanents tels qu'introduits ci-dessus à titre exemplatif, le champ magnétique généré par l'alignement Halbach présente une densité maximale à 2 mm sensiblement égale à 0,6 T et présente encore une densité maximale à 12 mm sensiblement égale à 0,1 T.

On comprend donc que, notamment selon cet agencement particulier, le dispositif de génération 12 est configuré pour générer un champ magnétique statique de densité suffisante pour être ressenti par la charge 20 en fusion dans la cage froide 10, et plus particulièrement au moins dans une épaisseur de peau électromagnétique 21 de la charge en fusion dans la cage froide.

Plus particulièrement, le champ magnétique statique généré par le dispositif de génération 12 est tel qu'il présente une densité sensiblement supérieure à 0,02 T, de préférence sensiblement supérieure à 0,05 T, à une distance sensiblement supérieure à 2 mm depuis son bord orienté vers l'intérieur de la cage froide 10.

En alternative ou en complément, le champ magnétique statique généré par le dispositif de génération 12 est tel qu'il présente une densité sensiblement comprise entre 0,07 et 0,8 T à une distance sensiblement comprise entre 0,1 et 12 mm depuis son bord orienté vers l'intérieur de la cage froide 10. De préférence, le champ magnétique statique généré par le dispositif de génération 12 est tel qu'il présente une densité sensiblement comprise entre 0,1 et 0,3 T à une distance sensiblement comprise entre 4 et 10 mm, depuis un des bords du dispositif de génération orienté vers l'intérieur de la cage froide 10.

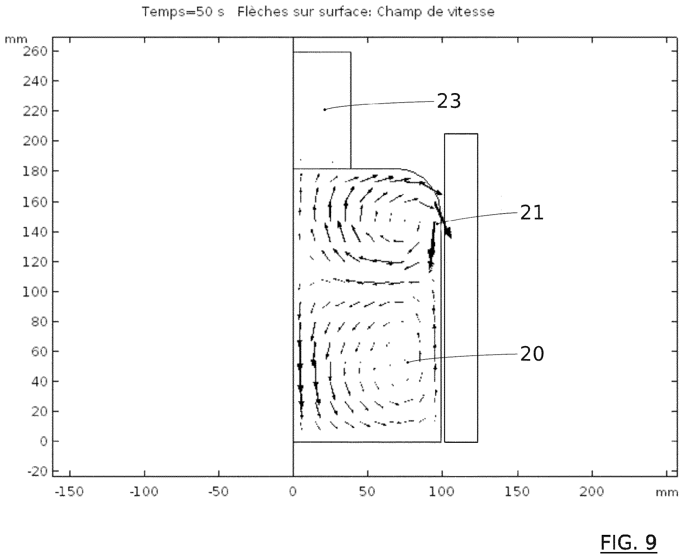

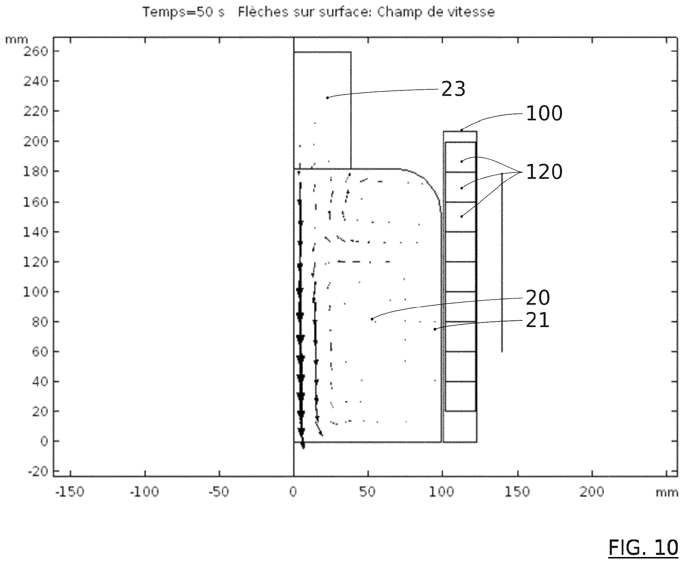

Un modèle numérique multi-physique a été développé qui permet de montrer l'efficacité du creuset froid selon l'invention. Sur la figure 10, nous montrons que l'utilisation des aimants permanents 120 dans les secteurs 100 modifie de façon non négligeable l'écoulement de la charge 20 en fusion (dans la simulation, le matériau est porté à une température sensiblement égale à 1690°C) dans le creuset froid 1. Cette modification se traduit par un freinage intense des vitesses de brassage dans les zones de la charge 20 en fusion les plus proches du creuset froid 1, mais aussi par une inversion des vortex de brassages, ceux-ci adoptant un sens de rotation plus favorable à la croissance d'un monocristal à partir d'un germe 23 que dans un creuset froid conventionnel (figure 9).

Le creuset froid selon l'invention permet donc d'une part de ralentir le brassage qui serait observé dans un creuset froid classique, d'autre part d'inverser le sens de recirculation des vortex induits dans la charge 20 en fusion.

L'utilisation d'un creuset froid « magnétique » selon l'invention permet, notamment par synergie des deux effets techniques énoncés ci-dessus, de favoriser la croissance de monocristaux de plus grande taille qu'un creuset froid classique. Plus particulièrement, l'utilisation d'un creuset froid « magnétique » selon l'invention permet de favoriser la croissance de monocristaux de plus grand diamètre que le diamètre du germe initiant la croissance et de meilleure qualité que celle obtenue par les techniques mettant en oeuvre des creusets chauds.

Un autre avantage lié à l'utilisation de creusets froids « magnétiques » selon l'invention apparaît lorsque l'on considère une charge constituée de différents matériaux présentant des différences de susceptibilité magnétique entre eux. Par exemple, une telle charge peut comprendre des matériaux ferromagnétique, paramagnétique ou diamagnétique. Un creuset froid « magnétique » selon l'invention peut alors permettre, du fait de la présence d'un gradient de champ magnétique statique s'étendant jusque dans la charge 20 en fusion, un tri sélectif de ces matériaux.

D'autres avantages peuvent être atteints via l'utilisation d'un creuset froid selon l'invention, notamment par intégration à l'intérieur de secteurs dont les logements ne sont pas occupés par des dispositifs de génération 12 et/ou permettent de loger au moins l'un parmi : un matériau à base de ferrite, une sonde de mesure ou un dispositif permettant de modifier ou analyser la charge en fusion. Le dispositif permettant de modifier ou analyser la charge en fusion peut notamment permettre de modifier ou analyser au moins une propriété de la charge en fusion, telle que l'écoulement de la charge. De façon nonlimitative, ce dispositif peut comprendre au moins l'un parmi un dispositif de génération d'un champ électromagnétique, de préférence un aimant permanent, une ferrite, un transducteur ultrasonore et un dispositif piézoélectrique. L'écoulement de la charge peut notamment être freiné, par exemple par un champ électromagnétique, et/ou son brassage peut être accentué, par exemple par des ultrasons.

D'autres avantages peuvent encore être atteints via l'utilisation d'un creuset froid selon l'invention, notamment par l'agencement entre eux des secteurs 100 logeant des dispositifs de génération 12. Les secteurs 100 peuvent en effet être agencés de l'une des façons suivantes :

- seuls deux secteurs opposés l'un à l'autre logent un dispositif de génération ;
- seuls trois secteurs agencés sensiblement selon une symétrie de rotation d'ordre 3 logent un dispositif de génération ;
- seuls quatre secteurs agencés sensiblement selon une symétrie de rotation d'ordre 4 logent un dispositif de génération ;

- un secteur sur deux secteurs adjacents loge un dispositif de génération ; et
- chaque secteur loge un dispositif de génération.

Outre, l'élaboration de monocristaux d'oxyde, tels que du saphir, le creuset froid selon l'invention permet d'élaborer des lingots de silicium monocristal de grandes dimensions, et en particulier de grand diamètre, notamment en vue d'applications dans le domaine de l'électronique de puissance.

L'invention n'est pas limitée aux modes de réalisations précédemment décrits et s'étend à tous les modes de réalisation couverts par les revendications.

Notamment, le creuset froid 1 selon l'invention peut être conçu par intégration du dispositif de génération 12 dans un creuset froid de n'importe quel type existant, dont un creuset froid à cage froide cylindrique, un creuset froid dit de poche, avec ou sans secteur(s) amovible(s), et un creuset froid dit à spire directe.

Un creuset froid en spire directe est constitué d'un unique secteur formant sensiblement un cylindre dans lequel est injecté le courant alternatif paramétré pour induire, dans la cage froide, une induction électromagnétique conduisant à la fusion de la charge. Ici, le secteur joue donc lui-même le rôle de la spire électrique qui est d'ordinaire agencée autour de la cage froide ; d'où son appellation « en spire directe ». Le secteur peut être réalisé en cuivre ou en un autre métal. Le dispositif de refroidissement de ce type de creuset peut être comme décrit plus haut du type à canal de circulation pour fluide caloporteur. Il est généralement brasé directement sur la surface externe du cylindre que forme l'unique secteur. En alternative, le cylindre peut être formé d'une double paroi logeant le dispositif de refroidissement. Le courant injecté dans ce cylindre produit des courants induits directement dans la charge et lorsque celle-ci est liquide, elle est contenue dans le cylindre. Cette technique est vraiment intéressante pour les grandes tailles de creuset froid, un tel creuset présentant typiquement un diamètre de l'ordre de 40 cm.

Ainsi, l'on comprend que, si la description de l'invention faite ci-dessus en référence aux figures concerne des creusets froids comprenant une pluralité de secteurs, l'invention n'est pas pour autant limitée à de tels creusets froids, et s'étend au creuset froid présentant un unique secteur. Au moins un dispositif de génération peut alors être logé dans une protubérance du cylindre ou au milieu de la double paroi, par exemple en s'étendant entre deux méandres du canal de circulation du fluide caloporteur destiné à permettre le refroidissement du secteur.

Par ailleurs, chaque dispositif de génération 12 n'est pas limité à son mode de réalisation comprenant au moins un aimant permanent. En effet, il est par exemple envisageable, bien que non préférentiel pour des raisons de difficultés de raccordement électrique notamment, que le champ soit électromagnétique et puisse être généré par au moins un électroaimant. Dès lors que le courant d'alimentation d'un tel électroaimant peut varier dans le temps faisant varier le champ magnétique généré par cet électroaimant, l'on comprend que le champ électromagnétique généré par un dispositif de génération 12 dans un creuset froid selon l'invention n'est pas nécessairement limité à un champ magnétique statique ; notamment, le champ électromagnétique généré par le dispositif de génération 12 peut être un champ magnétique quasi statique.

## Revendications

1. Creuset froid (1) comprenant :

   • une cage dite froide (10) comprenant au moins un secteur (100) en un matériau bon conducteur électrique, généralement en cuivre, et dans laquelle une charge (20) à fondre est destinée à être introduite, et
   • un dispositif de refroidissement (11) à fluide caloporteur, généralement de l'eau,
   le dispositif de refroidissement (11) étant configuré pour refroidir chaque secteur (100) de la cage froide (10),
   le creuset froid (1), comprenant en outre au moins un dispositif de génération (12) d'un champ électromagnétique, étant **caractérisé en ce que** chaque dispositif de génération (12) est logé à l'intérieur d'au moins un secteur (100) de la cage froide (10) du creuset froid (1).

2. Creuset froid (1) selon la revendication précédente, dans lequel le dispositif de génération (12) est configuré pour générer un champ magnétique statique.

3. Creuset froid (1) selon l'une quelconque des revendications précédentes, dans lequel le dispositif de génération (12) est configuré pour générer un champ électromagnétique, et de préférence un champ magnétique statique, de densité suffisante pour être ressenti par la charge (20) en fusion dans la cage froide (10), et plus particulièrement au moins dans une épaisseur de peau électromagnétique (21) de la charge en fusion dans la cage froide.

4. Creuset froid (1) selon l'une quelconque des revendications précédentes, dans lequel le champ électromagnétique, de préférence le champ magnétique statique, généré par le dispositif de génération (12) est tel qu'il présente une densité sensiblement supérieure à 0,02 T, de préférence sensiblement supérieure à 0,05 T, à une distance sensiblement supérieure à 2 mm depuis un des bords du dispositif de génération orienté vers l'intérieur de la cage froide (10).

5. Creuset froid (1) selon l'une quelconque des revendications précédentes, dans lequel le dispositif de génération (12) est plus particulièrement logé dans ledit au moins un secteur de sorte à se situer, par un de ses bords orienté vers l'intérieur de la cage froide (10), à une distance sensiblement inférieure à 12 mm, de préférence sensiblement inférieure à 9 mm, et encore plus préférentiellement sensiblement inférieure à 6 mm, de la charge (20) en fusion dans le creuset froid (1).

6. Creuset froid (1) selon l'une quelconque des revendications précédentes, dans lequel le dispositif de génération (12) est configuré dans le secteur qui le loge de sorte à être refroidi par le dispositif de refroidissement (11) du creuset froid (1).

7. Creuset froid (1) selon l'une quelconque des revendications précédentes, dans lequel le dispositif de génération (12) comprend au moins un aimant permanent (120).

8. Creuset froid (1) selon les deux revendications précédentes, dans lequel l'agencement conjoint de chaque aimant permanent (120) avec le dispositif de refroidissement (11) est configuré pour garantir le maintien de l'aimant permanent à une température strictement inférieure à la température de Curie de l'aimant permanent.

9. Creuset froid (1) selon l'une quelconque des deux revendications précédentes, dans lequel l'aimant permanent (120) est de préférence constitué en un matériau présentant une résistivité électrique supérieure à celle du matériau constitutif des secteurs (100) de la cage froide (10).

10. Creuset froid (1) selon l'une quelconque des revendications précédentes, dans lequel au moins un dispositif de génération (12) comprend une pluralité d'aimants permanents (120), les aimants permanents de chaque pluralité étant agencés entre eux de sorte à générer, au moins en direction de l'intérieur de la cage froide (10), un champ magnétique statique plus puissant que le champ magnétique statique généré par chaque aimant permanent (120) pris isolément.

11. Creuset froid (1) selon la revendication précédente, dans lequel les aimants permanents (120) de chaque pluralité sont agencés entre eux selon une configuration dite de Halbach.

12. Creuset froid (1) selon l'une quelconque des revendications précédentes, dans lequel, la cage froide (10) comprenant plusieurs secteurs (100), les secteurs (100) sont amovibles entre eux, le cas échéant le creuset froid (1) comprenant en outre un dispositif de fixation et de maintien (13) des secteurs entre eux, ce dernier étant configuré de sorte que les secteurs fixés et maintenus forment au moins une partie de la cage froide (10).

13. Creuset froid (1) selon l'une quelconque des revendications précédentes, dans lequel le dispositif de génération (12) comprend une première partie (12a) configurée pour générer le champ électromagnétique, de préférence pour générer le champ magnétique statique, et une deuxième partie, dite partie de support (12b), configurée pour supporter la première partie (12a) du dispositif de génération et pour coopérer étroitement avec le logement du dispositif de génération dans ledit au moins un secteur (100), la partie de support (12b) du dispositif de génération étant de préférence configurée pour supporter une pluralité d'aimants permanents (120) et pour former avec les parois intérieures de son logement (101) dans le secteur (100), et le cas échéant avec la première partie (12a) du d dispositif de génération qu'il supporte, un couloir de circulation pour le fluide caloporteur du dispositif de refroidissement (11).

14. Creuset froid (1) selon l'une quelconque des revendications précédentes, dans lequel chaque secteur (100) dont le logement (101) est exempt de dispositif de génération (12) peut loger au moins l'un parmi : un matériau à base de ferrite, une sonde de mesure, un dispositif de génération d'un champ électromagnétique, un transducteur ultrasonore et un dispositif piézoélectrique.

15. Creuset froid (1) selon l'une quelconque des revendications précédentes, dans lequel la cage froide (10) comprend plusieurs secteurs (100) et dont les secteurs (100) sont agencés de l'une des façons suivantes :

   • seuls deux secteurs opposés l'un à l'autre logent un dispositif de génération ;
   • seuls trois secteurs agencés sensiblement selon une symétrie de rotation d'ordre 3 logent un dispositif de génération ;
   • seuls quatre secteurs agencés sensiblement selon une symétrie de rotation d'ordre 4 logent un dispositif de génération ;
   • un secteur sur deux secteurs adjacents loge un dispositif de génération ; et
   • chaque secteur loge un dispositif de génération.

**Patentansprüche**

1. Kalttiegel (1), umfassend:

   • ein Kaltgehäuse (10), das mindestens einen Bereich (100) aus einem elektrisch gut leitenden Material, üblicherweise Kupfer, umfasst und wobei eine zu schmelzende Beschickung (20) vorgesehen ist, darin eingebracht zu werden, und
• eine Kühlvorrichtung (11) mit Wärmeträgerflüssigkeit, üblicherweise Wasser,
wobei die Kühlvorrichtung (11) konfiguriert ist, um jeden Bereich (100) des Kaltgehäuses (10) zu kühlen,
wobei der Kalttiegel (1), der ferner mindestens eine Erzeugungsvorrichtung (12) eines elektromagnetischen Feldes umfasst, **dadurch gekennzeichnet ist, dass** jede Erzeugungsvorrichtung (12) im Innern mindestens eines Bereichs (100) des Kaltgehäuses (10) des Kalttiegels (1) aufgenommen ist.

2. Kalttiegel (1) nach dem vorhergehenden Anspruch, wobei die Erzeugungsvorrichtung (12) konfiguriert ist, um ein statisches Magnetfeld zu erzeugen.

3. Kalttiegel (1) nach einem der vorhergehenden Ansprüche, wobei die Erzeugungsvorrichtung (12) konfiguriert ist, um ein elektromagnetisches Feld zu erzeugen, und vorzugsweise ein statisches Magnetfeld von ausreichender Dichte, um von der Beschickung (20) in der Schmelze im Kaltgehäuse (10) gespürt zu werden, und insbesondere mindestens in einer Dicke der elektromagnetischen Haut (21) der Beschickung in der Schmelze im Kaltgehäuse.

4. Kalttiegel (1) nach einem der vorhergehenden Ansprüche, wobei das von der Erzeugungsvorrichtung (12) erzeugte elektromagnetische Feld, vorzugsweise das statische Magnetfeld, derart ist, dass es eine Dichte aufweist, die im Wesentlichen über 0,02 T liegt, vorzugsweise im Wesentlichen über 0,05 T, bei einem Abstand von im Wesentlichen über 2 mm von einer Kante der Erzeugungsvorrichtung, die zum Innern des Kaltgehäuses (10) ausgerichtet ist.

5. Kalttiegel (1) nach einem der vorhergehenden Ansprüche, wobei die Erzeugungsvorrichtung (12) insbesondere im mindestens einen Bereich so aufgenommen ist, dass sie sich mit einem ihrer Ränder, der zum Innern des Kaltgehäuses (10) ausgerichtet ist, in einem Abstand von im Wesentlichen weniger als 12 mm, vorzugsweise im Wesentlichen weniger als 9 mm, und noch bevorzugter im Wesentlichen weniger als 6 mm von der Beschickung (20) in der Schmelze im Kalttiegel (1) befindet.

6. Kalttiegel (1) nach einem der vorhergehenden Ansprüche, wobei die Erzeugungsvorrichtung (12) so im Bereich konfiguriert ist, in dem sie aufgenommen ist, dass sie durch die Kühlvorrichtung (11) des Kalttiegels (1) gekühlt wird.

7. Kalttiegel (1) nach einem der vorhergehenden Ansprüche, wobei die Erzeugungsvorrichtung (12) mindestens einen Permanentmagneten (120) umfasst.

8. Kalttiegel (1) nach den zwei vorhergehenden Ansprüchen, wobei die gemeinsame Anordnung jedes Permanentmagneten (120) mit der Kühlvorrichtung (11) konfiguriert ist, um zu gewährleisten, dass der Permanentmagnet bei einer Temperatur gehalten wird, die streng unter der Curie-Temperatur des Permanentmagneten liegt.

9. Kalttiegel (1) nach einem der zwei vorhergehenden Ansprüche, wobei der Permanentmagnet (120) vorzugsweise aus einem Material besteht, das einen höheren elektrischen Widerstand aufweist als der des Materials, aus dem die Bereiche (100) des Kaltgehäuses (10) bestehen.

10. Kalttiegel (1) nach einem der vorhergehenden Ansprüche, wobei mindestens eine Erzeugungsvorrichtung (12) eine Vielzahl von Permanentmagneten (120) umfasst, wobei die Permanentmagnete jeder Vielzahl so untereinander eingerichtet sind, dass sie, mindestens in Richtung des Innern des Kaltgehäuses (10), ein statisches Magnetfeld erzeugen, das stärker ist als das statische Magnetfeld, das von jedem isoliert betrachteten Permanentmagneten (120) erzeugt wird.

11. Kalttiegel (1) nach dem vorhergehenden Anspruch, wobei die Permanentmagnete (120) jeder Vielzahl untereinander in einer Halbach-Konfiguration eingerichtet sind.

12. Kalttiegel (1) nach einem der vorhergehenden Ansprüche, wobei das Kaltgehäuse (10) mehrere Bereiche (100) umfasst, wobei die Bereiche (100) untereinander abnehmbar sind, wobei der Kalttiegel (1) gegebenenfalls ferner eine Vorrichtung zum Befestigen und Halten (13) der Bereiche untereinander umfasst, wobei letztere so konfiguriert ist, dass die befestigten und gehaltenen Bereiche mindestens einen Teil des Kaltgehäuses (10) bilden.

13. Kalttiegel (1) nach einem der vorhergehenden Ansprüche, wobei die Erzeugungsvorrichtung (12) einen ersten Teil (12a) umfasst, der zum Erzeugen des elektromagnetischen Feldes konfiguriert ist, vorzugsweise zum Erzeugen des statischen Magnetfeldes, und einen zweiten Teil, Trägerteil (12b) genannt, der zum Tragen des ersten Teils (12a) der Erzeugungsvorrichtung konfiguriert ist, und zum engen Zusammenwirken mit dem Sitz der Erzeugungsvorrichtung im mindestens einen Bereich (100), wobei der Trägerteil (12b) der Erzeugungsvorrichtung vorzugsweise konfiguriert ist, um eine Vielzahl von Permanentmagneten (120) zu tragen und mit den Innenwänden ihres Sitzes (101) im Bereich (100), und gegebenenfalls mit dem ersten Teil (12a) der Erzeugungsvorrichtung, den sie trägt, einen Zirkulationskorridor für die Wärmeträgerflüssigkeit der Kühlvorrichtung (11) zu bilden.

14. Kalttiegel (1) nach einem der vorhergehenden Ansprüche, wobei jeder Bereich (100), dessen Sitz (101) ohne eine Erzeugungsvorrichtung (12) ist, mindestens eines aufnehmen kann von: Einem Material auf Ferritbasis, einer Messsonde, einer Erzeugungsvorrichtung eines elektromagnetischen Feldes, einem Ultraschallwandler und einer piezoelektrischen Vorrichtung.

15. Kalttiegel (1) nach einem der vorhergehenden Ansprüche, wobei das Kaltgehäuse (10) mehrere Bereiche (100) umfasst und deren Bereichen (100) auf eine der folgenden Arten eingerichtet sind:

> • nur zwei Bereiche, die gegenüberliegen, nehmen eine Erzeugungsvorrichtung auf;
> • nur drei Bereiche, die im Wesentlichen nach einer Rotationssymmetrie der Ordnung 3 eingerichtet sind, nehmen eine Erzeugungsvorrichtung auf;
> • nur vier Bereiche, die im Wesentlichen nach einer Rotationssymmetrie der Ordnung 4 eingerichtet sind, nehmen eine Erzeugungsvorrichtung auf;
> • ein Bereich von zwei benachbarten Bereichen nimmt eine Erzeugungsvorrichtung auf; und
> • jeder Bereich nimmt eine Erzeugungsvorrichtung auf.

**Claims**

1. A cold crucible (1) comprising:

> • a cage called cold cage (10) comprising at least one sector (100) made of material that is a good conductor of electricity, generally copper, and into which a charge (20) to be melted is intended to be introduced, and
> • a cooling device (11) involving a heat-transfer fluid, usually water,

the cooling device (11) being configured to cool each sector (100) of the cold cage (10),
the cold crucible (1), further comprising at least one device (12) for generating an electromagnetic field, being **characterised in that** each generation device (12) is housed inside at least one sector (100) of the cold cage (10) of the cold crucible (1).

2. The cold crucible (1) according to the preceding claim, wherein the generation device (12) is configured to generate a static magnetic field.

3. The cold crucible (1) according to any one of the preceding claims, wherein the generation device (12) is configured to generate an electromagnetic field, and preferably a static magnetic field, of sufficient density to be felt by the molten charge (20) in the cold cage (10), and more particularly at least in a thickness of the electromagnetic skin (21) of the molten charge in the cold cage.

4. The cold crucible (1) according to any one of the preceding claims, wherein the electromagnetic field, preferably the static magnetic field, generated by the generation device (12) is such that it has a density substantially greater than 0.02 T, preferably substantially greater than 0.05 T, at a distance substantially greater than 2 mm from one of the edges of the generation device oriented towards the inside of the cold cage (10).

5. The cold crucible (1) according to any one of the preceding claims, wherein the generation device (12) is more particularly housed within said at least one sector so as to be located, by one of its edges oriented towards the inside of the cold cage (10), at a distance substantially less than 12 mm, preferably substantially less than 9 mm, and even more preferably substantially less than 6 mm, from the molten charge (20) in the cold crucible (1).

6. The cold crucible (1) according to any one of the preceding claims, wherein the generation device (12) is configured in the sector which houses it so as to be cooled by the cooling device (11) of the cold crucible (1).

7. The cold crucible (1) according to any one of the preceding claims, wherein the generation device (12) comprises at least one permanent magnet (120).

8. The cold crucible (1) according to the two preceding claims, wherein the joint arrangement of each permanent magnet (120) with the cooling device (11) is configured to ensure that the permanent magnet is maintained at a temperature strictly less than the Curie temperature of the permanent magnet.

9. The cold crucible (1) according to any one of the two preceding claims, wherein the permanent magnet (120) is preferably made of a material having an electrical resistivity greater than that of the material constituting the sectors (100) of the cold cage (10).

10. The cold crucible (1) according to any one of the preceding claims, wherein at least one generation device (12) comprises a plurality of permanent magnets (120), the permanent magnets of each plurality being arranged together so as to generate, at least towards the inside of the cold cage (10), a more powerful static magnetic field than the static magnetic field generated by each permanent magnet (120) taken in isolation.

11. The cold crucible (1) according to the preceding claim, wherein the permanent magnets (120) of each plurality are arranged together in a configuration called Halbach configuration.

12. The cold crucible (1) according to any one of the preceding claims, wherein, the cold cage (10) comprising several sectors (100), the sectors (100) are removable from one another, where appropriate the cold crucible (1) further comprising a device for fastening and holding (13) the sectors together, said device being configured so that the sectors fastened and held form at least part of the cold cage (10).

13. The cold crucible (1) according to any one of the preceding claims, wherein the generation device (12) comprises a first portion (12a) configured to generate the electromagnetic field, preferably to generate the static magnetic field, and a second portion, called support portion (12b), configured to support the first portion (12a) of the generation device and to cooperate closely with the housing of the generation device in said at least one sector (100), the support portion (12b) of the generation device being preferably configured to support a plurality of permanent magnets (120) and to form with the inner walls of its housing (101) in the sector (100), and where appropriate with the first portion (12a) of the generation device that it supports, a circulation corridor for the heat-transfer fluid of the cooling device (11).

14. The cold crucible (1) according to any one of the preceding claims, wherein each sector (100) whose housing (101) is free of a generation device (12) can house at least one of: a ferrite-based material, a measurement probe, a device for generating an electromagnetic field, an ultrasonic transducer and a piezoelectric device.

15. The cold crucible (1) according to any one of the preceding claims, wherein the cold cage (10) comprises several sectors (100) and the sectors (100) of which are arranged in one of the following ways:

   • only two sectors opposite each other house a generation device;
   • only three sectors arranged substantially in rotational symmetry of order 3 house a generation device;
   • only four sectors arranged substantially in rotational symmetry of order 4 house a generation device;
   • one sector out of two adjacent sectors houses a generation device; and
• each sector houses a generation device.

FIG. 1

FIG. 2

FIG. 3

FIG. 4

12

120
120
120
120
120
120
120
120
120
120 — 12a

12b

FIG. 5

100

101

12b

FIG. 6

100

12

FIG. 7

120

12a

FIG. 8

Temps=50 s   Flèches sur surface: Champ de vitesse

FIG. 9

Temps=50 s   Flèches sur surface: Champ de vitesse

FIG. 10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070147463 A1
- JP H1152095 A
- US 5109389 A
- DE 10042151 A1

**Littérature non-brevet citée dans la description**

- **WENCKUS et al.** GROWTH OF HIGH PURITY OXYGEN-FREE SILICON BY COLD CRUCIBLE TECHNIQUES. *Final technical report*
- **OSIKO et al.** CRUCIBLE-FREE METHODS OF GROWING OXIDE CRYSTALS FROM THE MELT. *Ann. Rev. Mater. Sci.,* 1987, vol. I7, 101-22
- **CISZEK.** Growth and Properties of (100) and (111) dislocation free silicon crystals from a cold crucible. *Journal of Crystal Growth,* 1984, vol. 70, 324-329
- **GILLON et al.** Uses of intense d.c. magnetic fields in materials processing. *Materials Science and Engineering,* 2000, vol. A287, 146-152